# FASCICULE DE BREVET EUROPEEN

(11) **EP 2 697 829 B1**
(45) Date de publication et mention de la délivrance du brevet: **09.09.2015**
(21) Numéro de dépôt: 12715207.2
(22) Date de dépôt: 02.04.2012
(51) Int. Cl.: H01L 27/32, H01L 51/52

(54) **DISPOSITIF OPTOELECTRONIQUE ORGANIQUE ET SON PROCEDE D'ENCAPSULATION**
ORGANISCHE OPTOELEKTRONISCHE VORRICHTUNG UND VERKAPSELUNGSVERFAHREN DAFÜR
ORGANIC OPTOELECTRONIC DEVICE AND THE ENCAPSULATION METHOD THEREOF

(30) Priorité: 11.04.2011 FR 1153125
(43) Date de publication de la demande: 19.02.2014
(73) Titulaire: Commissariat à l'Énergie Atomique et aux Énergies Alternatives, 75015 Paris (FR)
(72) Inventeur: MAINDRON, Tony, F-38000 Grenoble (FR); AVENTURIER, Bernard, F-38134 Saint Joseph De Riviere (FR); SIMON, Jean-Yves, F-38600 Fontaine (FR)
(74) Mandataire: Bolinches, Michel Jean-Marie
(86) Numéro de dépôt international: PCT/IB2012/051605
(87) Numéro de publication internationale: WO 2012/140539

(56) Documents cités:
- FR-A1- 2 936 651
- JP-A- 2005 353 500
- US-A1- 2011 031 514

## Description

La présente invention concerne un dispositif optoélectronique organique, tel qu'un dispositif d'affichage, d'éclairage ou de signalisation, qui est protégé de l'atmosphère ambiante par une encapsulation étanche de type incluant des couches minces, et un procédé d'encapsulation d'un tel dispositif. L'invention s'applique notamment à des dispositifs à diodes électroluminescentes organiques (« OLED ») tels que des écrans de type « AM-OLED » (i.e. à diodes « OLED » et à matrice active) quelles que soient leurs dimensions, ou tels que des dispositifs d'extraction de lumière par réfraction.

De manière connue, les dispositifs optoélectroniques organiques, tels que les « OLED », les dispositifs à cellules photovoltaïques organiques (« OPVC » en anglais pour « organic photovoltaic cells ») et ceux à transistors « TFT » organiques nécessitent d'être encapsulés, pour assurer la protection de leurs composants sensibles contre les espèces gazeuses de l'atmosphère (principalement l'oxygène et la vapeur d'eau). En effet, si cette protection n'est pas convenablement réalisée, il risque de se produire une dégradation ultérieure du dispositif qui se manifeste principalement par l'apparition de points noirs non émissifs dans le cas des « OLED », qui sont en fait la résultante de la pénétration de la vapeur d'eau dans la diode, ce qui dégrade l'interface entre cathode (ou anode) et film(s) organique(s).

Cette encapsulation peut être typiquement réalisée grâce à l'utilisation d'un capot de verre collé sur le dispositif organique à l'aide d'une colle spécifique présentant notamment une faible perméabilité à l'eau. En général, on ajoute un absorbeur d'humidité solide ou « getter » entre le substrat et le capot pour prolonger la durée de vie du dispositif.

Pour certaines applications mais aussi pour une question de réduction de coût, on a développé des couches minces inorganiques à effet de barrière dont le rôle, par similitude à cet ensemble capot-getter, est de protéger le dispositif sous-jacent de l'agression de l'humidité. D'une manière générale, ces couches barrières sont des oxydes comme de préférence Al₂O₃, des nitrures ou des oxynitrures ou, dans certains cas, il peut s'agir de couches minces métalliques sauf si l'unité électroluminescente émet par le sommet de la structure (« top émission » en anglais) auquel cas les couches barrières doivent être transparentes.

Ces couches minces sont déposées par des procédés standards de dépôt sous vide tels que le dépôt chimique en phase vapeur (« CVD ») éventuellement assisté par plasma (« PECVD »), le dépôt de couche atomique (« ALD », parfois appelée « AL-CVD ») ou par des procédés de dépôt physique en phase vapeur (« PVD ») incluant l'évaporation et la pulvérisation. Pour l'effet de barrière, on privilégie notamment les technologies « CVD » et en particulier « ALD » qui, à basse température donnent des couches barrières denses, avec peu de défauts (« pinholes » en anglais pour trous d'aiguilles) et 100 % conformes à des températures le plus souvent inférieures à 110° C qui sont compatibles avec les « OLED ». A basse température, il a ainsi été montré une densité de défauts d'une couche Al₂O₃ déposée par « ALD » aussi faible que 38/cm². Pour des applications de microécrans, cette densité de défauts est néanmoins trop élevée car si l'on considère une surface de microécran de 45 mm², cela conduit à 17 défauts par microécran soit potentiellement 17 points noirs sur l'afficheur « OLED ». En effet, même si ces points noirs intrinsèques à la fabrication sont microscopiques, leur présence est prohibée sur un dispositif « OLED » dont l'image est magnifiée par une optique adaptée, et il faut en outre leur ajouter les points noirs « extrinsèques » dus à la présence de particules indésirables à la surface du dispositif lors de l'encapsulation en couches minces.

Par ailleurs, on sait qu'il faut protéger de l'eau sur le long terme l'Al₂O₃ déposé par « ALD » car il a tendance à s'hydrolyser en Al(OH)ₓ. On a donc cherché à passiver de manière pérenne cette barrière que constitue un tel film d'Al₂O₃ par des matériaux inorganiques plus inertes chimiquement et plus stables tels que SiO₂, Si₃N₄ ou SiOₓN_{y}, via des dépôts mis en oeuvre par « PECVD » à basse température qui permettent également de boucher les défauts résiduels de ces films d'Al₂O₃.

En variante, on a cherché à passiver ces films d'Al₂O₃ déposés par « ALD » par des couches organiques relativement épaisses à base de polymères « planarisants » censés remédier à l'inconvénient des particules indésirables précitées en les enrobant à la manière d'un empilement Barix™ de la société Vitex, avec un empilement de couches organiques et inorganiques alternées. Un inconvénient de cette solution réside dans le procédé en phase gazeuse de type évaporation « flash » (i.e. évaporation du monomère, condensation sur substrat puis insolation UV pour la réticulation) qui est relativement coûteux en temps.

Il est difficile d'envisager d'autres types de dépôt moins coûteux en temps comme le dépôt en phase liquide, car ce type de dépôt nécessite l'utilisation de solutions polymériques contenant des solvants susceptibles de dissoudre les couches de l'unité électroluminescente sous-jacente.

La Demande de Brevet FR1001522 du 12 avril 2010 au nom de la Demanderesse propose un dispositif optoélectronique organique par exemple de type « OLED » qui remédie à ces inconvénients, ce dispositif présentant une unité électroluminescente présentant une zone active revêtue d'une structure multicouches d'encapsulation étanche et une zone de connexion électrique adjacente, la structure d'encapsulation comprenant au moins un empilement film inorganique F1 / couche de résine photosensible C1 où le film F1 recouvre la zone active et est surmonté par la couche C1 qui est déposée en phase liquide, gravée par photolithographie et recouvre le film F1 en s'étendant autour de la zone active en une portion enveloppante structurée se terminant en deçà de la zone de connexion, de sorte que la couche C1 passive le film F1 et protège latéralement la zone active des solvants et solutions de développement utilisés pour la gravure de la couche C1. Cette dernière est avantageusement recouverte d'un film barrière inorganique externe Fe qui surmonte à la fois la zone active en recouvrant la totalité de la couche C1 et sa zone de connexion, de sorte à isoler de l'extérieur la portion enveloppante de la couche C1.

Cette Demande de Brevet mentionne également la possibilité de mettre en oeuvre, suite au développement de la couche enveloppante de résine, une gravure sèche de cette couche par exemple par gravure ionique réactive (« RIE ») ou par un plasma d'oxygène, pour réduire son épaisseur et donc l'épaisseur totale de l'empilement et ainsi satisfaire aux spécifications des microécrans concernant le problème des perturbations entre pixels (« cross-talk » en anglais, i.e. pour ne pas gêner l'émission entre pixels voisins lorsque des filtres colorés sont utilisés).

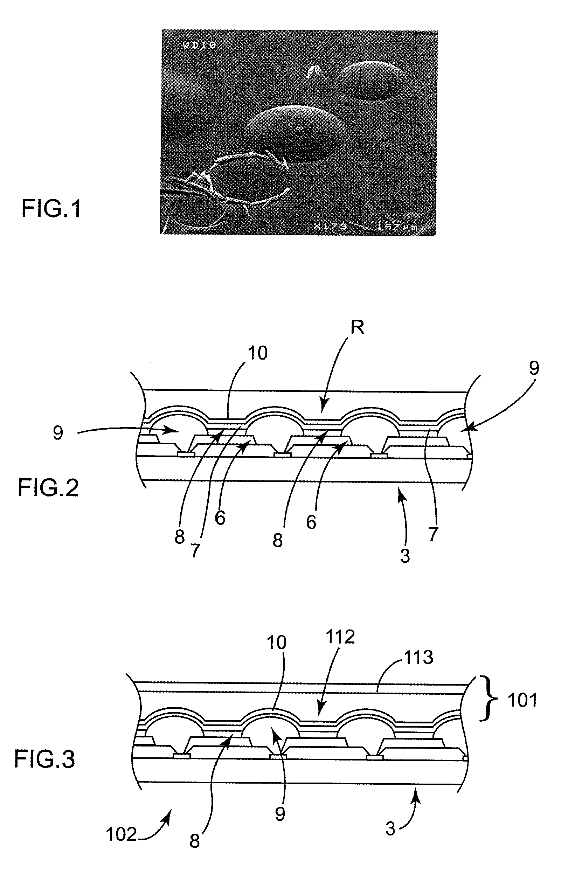

La Demanderesse a constaté que dans certains cas, par exemple pour de grandes tailles d'écrans ou à la suite de certains traitements thermiques, des cloques pouvaient apparaître à la surface du film externe recouvrant la résine (voir la figure 1 annexée à la présente description). Ces cloques semblent d'autant plus nombreuses que le volume de résine sous-jacent est plus important. L'apparition des cloques semble donc liée à un phénomène de dégazage de la résine. Pour pallier cet inconvénient, on peut prévoir d'amincir la résine (pour en diminuer le volume total), par exemple par l'action d'un plasma.

Cependant, un inconvénient de cette solution consistant à amincir dans une proportion significative la résine photosensible pour éviter ce cloquage réside dans le risque en résultant de pénaliser l'homogénéité d'épaisseur entre les bords et le centre du dispositif ainsi qu'à l'échelle du circuit intégré (en raison de l'inhomogénéité entre bords et centre). Ce risque est d'autant plus marqué que la taille du dispositif est plus grande. De plus, les propriétés barrière de l'encapsulation peuvent être pénalisées par un tel amincissement de la résine.

JP2005353500 décrit un film barrière pour un dispositif électronique comprenant une première couche barrière, une couche intermédiaire présentant une structure en forme de lentilles et une deuxième couche barrière.

US2001/0031514 décrit une couche de protection pour une OLED ayant une structure en forme de lentilles.

Un but de la présente invention est de proposer un dispositif optoélectronique organique, tel qu'un dispositif d'affichage, d'éclairage ou de signalisation de type « OLED » ou « OPVC », qui permette de remédier à l'ensemble des inconvénients précités en évitant notamment ce phénomène de cloquage et en proposant pour l'encapsulation une solution alternative à cet amincissement, ce dispositif comprenant une face utile (i.e. la face d'émission électroluminescente pour les « OLED » ou d'absorption pour les « OPVC ») et, vers l'intérieur de cette face, un substrat revêtu d'une matrice de n structures organiques (émettrices de rayonnements pour l'« OLED », absorbant le rayonnement pour l'« OPVC ») intercalée entre et en contact électrique avec des électrodes respectivement proximales et distale vis-à-vis du substrat, des cordons de séparation entre structures organiques réalisés en un matériau électriquement isolant (e.g. une résine ou un film d'un oxyde ou d'un nitrure) s'étendant entre les électrodes proximales respectives de ces structures à partir de bords périphériques des électrodes proximales, le dispositif comportant une encapsulation étanche à couches minces qui comprend au moins un film inorganique interne surmontant l'électrode distale, une couche polymérique photosensible recouvrant ce film interne, et un film inorganique externe diélectrique et à effet de barrière recouvrant cette couche polymérique.

A cet effet, un dispositif selon l'invention est tel que ladite au moins une couche polymérique est gravée suivant une géométrie discontinue formée de n plots qui surmontent respectivement ces n structures organiques et qui se terminent au-delà de ces dernières au droit desdits cordons, de sorte que les plots deux à deux adjacents soient espacés d'une distance inférieure à la largeur des cordons, chaque plot présentant un sommet plan et des flancs également plans sensiblement perpendiculaires audit sommet.

On notera que l'on obtient ainsi une encapsulation à l'échelle de chaque structure organique émettrice ou absorbante (qui est par exemple dans le cas d'un écran constituée d'un pixel ou d'un sous-pixel, comme expliqué ci-après), contrairement à l'encapsulation à l'échelle de la zone active obtenue dans la Demande de Brevet précitée, et que cette géométrie discontinue en forme de plots de la ou de chaque couche photosensible permet de réduire d'une manière significative le volume total de cette couche recouverte par le film externe à effet de barrière, du fait de l'espace libre entre les plots, en facilitant ainsi le dégazage de la couche photosensible suite à son dépôt et avant celui du film externe, ce qui permet de minimiser le risque d'apparition de cloques à la surface de ce film externe même dans des conditions de recuit ou de vieillissement à haute température (pouvant être égale ou supérieure à 85° C).

On notera également que cette structure gravée de la ou de chaque couche photosensible peut être précisément obtenue par photolithographie, c'est-à-dire par insolation locale de la couche photosensible au moyen d'un masque et d'un développement de cette couche, cette gravure permettant de structurer et donc de former précisément ces plots.

Selon une autre caractéristique de l'invention, chacun desdits plots déborde de la structure organique sur laquelle il est centré d'une portion périphérique de dépassement, laquelle présente une largeur inférieure à la demi-largeur dudit cordon correspondant.

Avantageusement, la surface développée de l'ensemble desdits plots (correspondant à la surface d'échange à travers laquelle le dégazage a lieu) est supérieure à la surface externe qu'aurait ladite au moins une couche polymérique si elle recouvrait de manière continue ledit au moins un film interne suivant une hauteur égale à celle desdits plots.

Selon un exemple de réalisation de l'invention, lesdits plots sont à base d'une résine positive de photolithographie qui est déposée en phase liquide sous forme d'au moins un polymère en solution dans un solvant, cette résine étant de préférence de dénomination « TELR ». Par « résine positive », on entend de manière connue une résine qui se polymérise lors de son dépôt, les parties insolées au rayonnement UV sélectivement à travers un masque étant dépolymérisées puis dissoutes lors du développement. En variante, cette résine peut être négative (i.e. par définition sa zone insolée se polymérise, devenant ainsi insoluble lors du développement, et subsiste dans l'empilement final).

Selon une autre caractéristique de l'invention, lesdits plots peuvent présenter une hauteur égale ou supérieure à 1 µm.

Avantageusement, ledit au moins un film interne et/ou externe peu(ven)t être déposé(s) par dépôt « ALD » ou par « PECVD », et être à base d'au moins un composé inorganique choisi dans le groupe constitué par les composés de formule AlₓO_{y}, SiOₓ, SiₓN_{y}, SiOₓN_{y}, ZnSe, Sb₂O₃ et les oxydes transparents conducteurs (OTC) optionnellement combinés à un métal.

Egalement avantageusement, ledit au moins un film interne et/ou externe peu(ven)t être déposé(s) par « ALD » et être à base d'au moins un oxyde d'aluminium Al₂O₃ optionnellement combiné à un composé de formule SiOₓ, SiₓN_{y} ou SiOₓN_{y}.

Avantageusement, un dispositif selon l'invention peut être de type « AM-OLED » (i.e. à diodes électroluminescentes organiques et à matrice active). Ce dispositif « AM-OLED » peut avantageusement former un écran dans lequel lesdites structures organiques émettrices forment respectivement des pixels ou des sous-pixels, cet écran formant par exemple un écran couleur où chaque pixel est défini par des sous-pixels R, V, B qui sont respectivement formés par lesdites structures émettrices surmontées par lesdits plots.

En variante, ce dispositif « AM-OLED » peut former un dispositif d'extraction de lumière par réfraction dont lesdits plots forment autant de dioptres entre un premier milieu constitué de ladite couche polymérique et un second milieu par exemple moins réfringent qui est extérieur au dispositif. Ces plots peuvent dans ce cas présenter des faces externes convexes à la manière de lentilles recouvertes par des ondulations correspondantes dudit film externe.

Un tel dispositif de type écran peut être recouvert d'un capot de protection (par exemple en verre ou en matière plastique) qui est pourvu sur sa face interne de filtres optiques colorés R, V, B disposés en regard des sous-pixels correspondants de chaque pixel et qui est assemblé sous pression sur celui-ci via une colle (de préférence acrylate ou époxy) réticulable par un rayonnement UV. En variante, les filtres colorés peuvent être réalisés directement sur les couches d'encapsulation du dispositif.

En variante, les pixels de la matrice peuvent ne pas être adressés individuellement comme dans le cas d'un dispositif « AM-OLED », pour former un panneau éclairant par exemple.

Un procédé d'encapsulation selon l'invention d'un dispositif tel que défini ci-dessus comprend les étapes successives suivantes :
a) on dépose ledit film inorganique interne au-dessus desdites structures organiques et desdits cordons par exemple directement sur ladite électrode distale, par un dépôt de couche atomique (« ALD ») ou bien par un dépôt chimique en phase vapeur assisté par plasma (« PECVD »), ce film étant à base d'au moins un composé inorganique de préférence choisi dans le groupe constitué par les composés de formule AlₓO_{y}, SiOₓ, SiₓN_{y}, SiOₓN_{y}, ZnSe, Sb₂O₃ et les oxydes transparents conducteurs (OTC) optionnellement combinés à un métal,
b) on recouvre de manière continue ce film interne par la couche photosensible que l'on dépose en phase liquide sous forme d'au moins un polymère dissous dans un solvant, optionnellement en déposant au préalable sur ce film un promoteur d'adhésion par exemple de type silane,
c) on insole cette couche à des emplacements prédéterminés en la masquant sélectivement des rayonnements d'insolation pour qu'elle soit, d'une part, polymérisée suite à cette insolation au-dessus de chaque structure organique et sur une portion périphérique de dépassement de chaque structure organique se terminant au droit dudit cordon l'entourant, et, d'autre part, dépolymérisée ailleurs, de sorte à former lesdits plots espacés surmontant respectivement les structures organiques en les enrobant pour les protéger vis-à-vis de l'étape d),
d) on développe cette couche polymérisée par trempage dans un bain par exemple de type tétraméthyl ammonium hydroxyde, puis
e) on réalise un dépôt conformant à basse température dudit film externe à effet de barrière sous forme de couche recouvrant de manière continue les plots, ce dépôt conformant étant de préférence réalisé par un dépôt de couche atomique (« ALD ») ou un dépôt chimique en phase vapeur assisté par plasma (« PECVD ») d'au moins un composé diélectrique.

Avantageusement, on peut en outre mettre en oeuvre avant l'étape c) et/ou après l'étape d) une étape d'amincissement de ladite couche photosensible.

Egalement avantageusement, on peut en outre mettre en oeuvre, après l'étape d) ou après l'étape e), une étape de traitement thermique à une température qui est compatible avec la tenue en température du matériau organique et qui peut être comprise entre 60° C et 100° C pour faciliter le dégazage de ladite couche photosensible.

On notera que les étapes a) et e) sont de préférence mises en oeuvre par « ALD », dépôt réalisable à basse température et permettant d'obtenir un film de densité élevée et de perméabilité très réduite qui épouse au plus près les micro- ou nanoreliefs de la surface sous-jacente.

On notera également que ce film interne déposé par « ALD » permet l'usage de solvants polaires ou apolaires, e.g. l'éthanol, l'eau, acétone et de solutions de développement/stripping de résines photosensibles telles que celles de dénominations TMAH et ROR.

Quant à l'étape b), elle peut être mise en oeuvre par toute technique d'enduction comme par exemple à la tournette ou via un revêtement par immersion ou « dip-coating ».

De préférence, on utilise à titre de polymère photosensible une résine positive de photolithographie et, à l'étape c), l'on masque sélectivement la couche photosensible surmontant chaque structure organique au moyen d'un masque débordant de celle-ci pour que cette couche y soit protégée de l'insolation en demeurant polymérisée, au contraire du reste de cette couche qui est dépolymérisée par cette insolation en vue de sa dissolution.

D'autres avantages, caractéristiques et détails de l'invention ressortiront du complément de description qui va suivre en référence aux dessins annexés, donnés uniquement à titre d'exemples et dans lesquels :
la figure 1 est un cliché au MEB (microscope électronique à balayage) d'un dispositif d'affichage « OLED » représentant des cloques apparues sur un film barrière externe en Al₂O₃ déposé sur une résine photosensible de « TELR » façonnée selon l'art antérieur, après un stockage en chambre climatisée,
la figure 2 est une vue schématique en coupe transversale d'un dispositif selon l'invention montrant le résultat de l'étape b) précitée de son procédé de fabrication, avec un film inorganique interne recouvert d'une couche photosensible déposée par voie liquide,
la figure 3 est une vue schématique en coupe transversale d'un dispositif non conforme à l'invention dans lequel le film externe à effet de barrière recouvre la couche photosensible qui surmonte de manière continue l'ensemble des structures émettrices du dispositif,
la figure 4 est une vue schématique en coupe transversale d'un dispositif selon l'invention montrant le résultat de l'étape d) précitée de son procédé de fabrication, montrant la structuration de la couche photosensible déposée à la figure 2 sous forme de plots espacés surmontant respectivement les structures émettrices du dispositif,
la figure 5 est une vue schématique en coupe transversale d'un dispositif selon l'invention montrant le résultat de l'étape e) précitée de son procédé de fabrication, dans lequel le film externe à effet de barrière recouvre les plots de résine photosensible de la figure 4, et
la figure 6 est une vue schématique en coupe transversale d'un autre dispositif non conforme à l'invention qui est apte à permettre l'extraction de lumière par réfraction via ses plots de résine photosensible qui forment autant de dioptres entre un premier milieu constitué de ces plots et un second milieu extérieur au dispositif.

L'encapsulation multicouches 1, 1' illustrée sur ces figures recouvre par exemple la face d'émission externe d'un dispositif optoélectronique électroluminescent 2, 2' dont les composants sensibles sont à protéger de l'humidité et de l'oxygène de l'air ambiant.

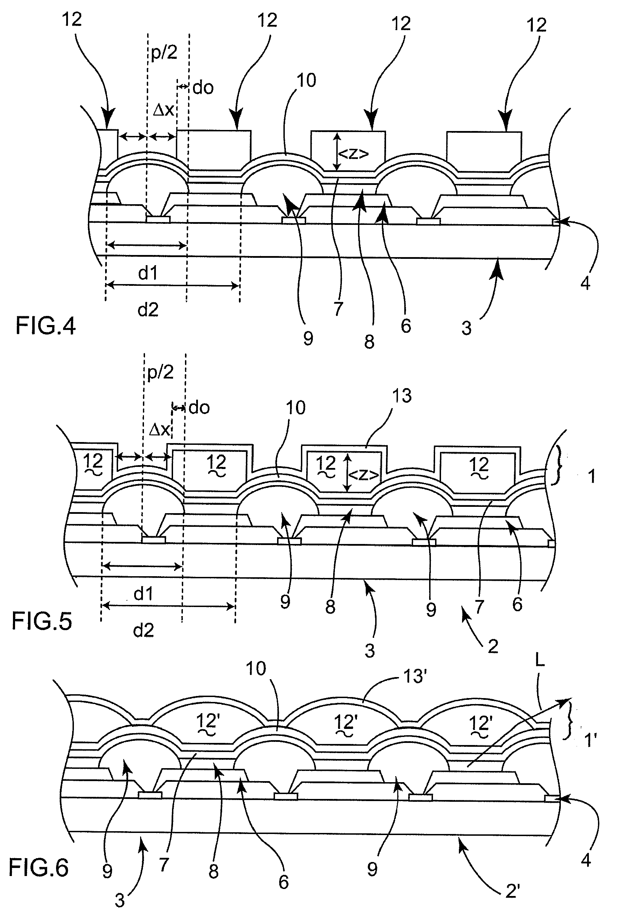

Les dispositifs optoélectroniques 2 et 2' respectivement illustrés aux figures 5 et 6 sont chacun par exemple de type « OLED », comprenant de manière connue un substrat 3 typiquement en silicium revêtu d'une unité électroluminescente 4 définissant une zone active et une zone de connexion électrique adjacente (non représentée). L'unité électroluminescente 4 comporte des électrodes internes 6 et externe 7 entre lesquelles sont intercalées des structures émettrices de lumière 8 (voir figure 2, formant par exemple des pixels ou même des sous-pixels dans le cas particulier d'écrans), l'une au moins des électrodes (dans cet exemple l'électrode externe 7 telle que la cathode) étant transparente ou semi-transparente à la lumière émise afin de la faire rayonner via la zone active vers l'extérieur du dispositif 2, 2'.

L'électrode externe 7 est de préférence constituée d'un métal tel que l'argent, l'aluminium ou le samarium pour les propriétés de transparence de ces métaux dans le domaine visible ainsi que pour leur conductivité électrique à faible épaisseur (l'épaisseur de l'électrode externe 7 est par exemple comprise entre 10 nm et 30 nm). Chaque structure émettrice « OLED » 8 est par exemple constituée d'un empilement de films organiques conçu pour transférer les électrons et les trous qui proviennent des électrodes et qui sont recombinés pour générer des excitons et donc l'émission de lumière.

De manière également connue, des cordons de séparation 9 réalisés en un matériau électriquement isolant (e.g. en une résine électriquement isolante ou en un oxyde ou nitrure) séparent les structures émettrices 8 deux à deux adjacentes en s'étendant à partir de bords périphériques respectifs des électrodes internes 6.

Comme notamment visible aux figures 5 et 6, l'encapsulation multicouches 1 selon ces exemples de l'invention comprend :
- un film inorganique interne 10 de « pré-encapsulation » qui est déposé de préférence par « ALD » sur la totalité de la zone active de l'unité « OLED » 4, et qui est par exemple à base d'un oxyde Al₂O₃ déposé selon une épaisseur comprise entre 5 nm et 50 nm, typiquement entre 10 nm et 25 nm,
- n plots 12 à base d'une résine photosensible R par exemple positive répondant à la dénomination « TELR-P002 » ou « JSR420 », qui recouvrent respectivement ces n structures émettrices 8 et qui se terminent au-delà de ces dernières au droit des cordons 9, de sorte que les plots 12 deux à deux adjacents soient espacés d'une distance 2Δx inférieure à la largeur d₁ des cordons 9 (d₁ étant mesurée dans la direction transversale des figures 4 et 5), et
- un film inorganique diélectrique externe 13 à effet de barrière (visible à la figure 5) qui recouvre continûment la totalité des faces des plots 12, les parties du film 10 non recouvertes par ces plots 12 ainsi que la zone de connexion électrique de l'unité 4, ce film 13 étant de préférence à base d'Al₂O₃ déposé par « ALD ».

Plus précisément en référence au dispositif 2 de la figure 5, on commence par déposer le film interne 10 sur l'électrode externe 7 ou sur une couche supplémentaire, communément appelée « capping layer », qui peut avantageusement être préalablement déposée sur l'électrode externe 7 (cette couche, en rupture d'indice, sert à améliorer le coefficient d'extraction lumineux de la structure émettrice « OLED », et il peut s'agir par exemple d'une couche de SiOₓ, évaporée à travers un pochoir à la dimension de l'écran, comme l'électrode externe 7). Comme visible à la figure 2, ce film 10 épouse ici en alternance la forme arrondie des cordons 9 et la forme plate des structures émettrices 8 séparées par ces cordons 9.

Puis, comme visible à la figure 2, on dépose par voie liquide (par exemple à la tournette) sur le film interne 10 cette résine photosensible R dissoute dans un solvant pour qu'elle recouvre continûment le film 10. On peut à ce stade amincir cette résine R.

Mais contrairement à l'encapsulation 101 de la figure 3 non conforme à l'invention dans laquelle le film inorganique diélectrique externe 113 à effet de barrière recouvre une face externe plane et continue de la résine photosensible 112 polymérisée et développée, l'encapsulation 2 de la figure 5 comprend à titre de couche polymérique photosensible une couche discontinue 12 (voir figure 4) obtenue par :
- insolation de la résine R à des emplacements prédéterminés en la masquant sélectivement des rayonnements d'insolation pour qu'elle soit polymérisée au-dessus de chaque structure émettrice 8 et sur une portion périphérique de dépassement d₀ de chaque structure 8 se terminant au droit du cordon 9 l'entourant et dépolymérisée ailleurs, de sorte à former les plots 12 espacés entre eux d'une distance 2Δx qui surmontent respectivement les structures 8 en les enrobant pour les protéger vis-à-vis de l'étape de développement, puis par
- développement de la résine R polymérisée ainsi insolée par trempage dans un bain (e.g. de type tétraméthyl ammonium hydroxyde).

Il est possible à ce stade d'amincir les plots 12 de résine R.

Quant au film externe 13 recouvrant ces plots 12, on voit à la figure 5 qu'il épouse le profil des sommets plans et des flancs également plans de ces plots 12 dans cet exemple de réalisation, ces flancs ou faces latérales étant ici sensiblement perpendiculaires au sommet de chaque plot 12.

Comme visible à la figure 4, chaque plot 12 déborde de la structure émettrice 8 sur laquelle il est centré de la portion périphérique de dépassement d₀, qui est de largeur inférieure à la demi-largeur d₁/2 du cordon 9 (cette demi-largeur est également identifiée par le demi-pas p/2) et, dans cet exemple inférieure au quart d₁/4 de la largeur de ce cordon 9. Si l'on considère le pas d₂ entre deux cordons 9 consécutifs, on voit que le volume V de résine photosensible R utilisée pour les plots 12, sur cette longueur d₂ et pour une hauteur <z> donnée des plots 12, est :
V = (d₂ - 2Δx).<z> (il s'agit d'un volume par unité de longueur dans l'autre direction horizontale y perpendiculaire aux directions x et z).

Alors que dans le cas de la figure 3, on a Δx = 0 et donc ce même volume V = d₂.<z> (toujours par unité de longueur dans la direction y), on a avec la présente invention la relation 0 < Δx < d₁/2, de sorte que la résine photosensible R de chaque plot 12 recouvre parfaitement la surface de la structure émettrice 8 correspondante (i.e. la surface de chaque pixel dans le cas d'un écran), en surmontant une surface minimale du cordon 9 définie par la portion de dépassement d₀.

La Demanderesse a réalisé des écrans « AM-OLED » conformes à la figure 5 avec d₁ = 1,569 µm et d₂ = 5,098 µm, avec à chaque fois la condition nécessaire pour la portion de dépassement d₀ de chaque plot 12 d'être inférieure à d₁/2, soit d₀ < 0,784 µm.

A titre de comparaison avec un écran 102 selon la figure 3 non conforme à l'invention dans lequel on a un unique plot photosensible 112 surmontant toute la zone active, soit une surface enveloppante d'environ 5 x 5 µm², les plots photosensibles 12 espacés entre eux du dispositif 2 selon l'invention surmontent chacun uniquement un pixel de la zone active de l'écran, ce qui définit pour la couche de résine photosensible R une surface enveloppante totale de seulement 3,5 x 3,5 µm². On peut donc supprimer 25 % environ de résine photosensible à l'échelle de l'écran par ce dispositif 2 de l'invention, et donc améliorer d'une manière significative le dégazage de cette résine avant le dépôt du film barrière externe 13. En effet et comme expliqué plus haut, on a une diminution de ce dégazage par réduction de la quantité de résine photosensible R devant dégazer, et ce dégazage est également facilité par la surface libre ménagée entre les plots 12 de résine.

Dès lors que les surfaces deviennent importantes, on notera que la réduction de la surface de résine photosensible R utilisée autorise un dégazage efficace de cette résine après son dépôt à des températures acceptables par l'unité « OLED » 4 sous-jacente.

Le dispositif 2' selon la variante non conforme à l'invention de la figure 6 est également par exemple de type « AM-OLED » mais il a ses plots 12' qui forment autant de dioptres pour améliorer l'extraction de la lumière émise par les structures 8, grâce au façonnage de ces plots 12' sous forme de lentilles convexes afin d'améliorer le coefficient de couplage de sortie. Plus précisément, on voit à la figure 6 que chacun de ces plots 12' a ses flancs et son sommet qui forment ensemble une surface externe continûment convexe. Quant au film externe inorganique 13' à effet de barrière qui recouvre ces plots 12', il présente, d'une part, de courtes zones creuses Z1 convexes épousant les sommets respectifs du film interne 10 (i.e. au droit des sommets des cordons 9) et, d'autre part, de longues zones sommitales Z2 également convexes qui surmontent de manière débordante les structures émettrices 8.

Dans cette application non conforme à l'invention, les indices des milieux doivent toutefois être considérés, avec par exemple un indice de réfraction de 1,5 pour ces plots 12' et un indice de réfraction égal à 1 pour l'extérieur du dispositif 2'. Le trajet L de la lumière émise et réfractée par une structure 8 est schématisé à la figure 6. On pourra par exemple se reporter à l'article High-Efficiency Organic Light-Emitting Diodes, Patel, N. K., Cina, S. and Burroughes, J. H. , IEEE Jour. Sel. Topics Quant. Elec. 8 (2002) 346-361 pour la description du fonctionnement d'un tel dispositif d'extraction de lumière à coefficient de couplage de sortie amélioré.

## Revendications

1. Dispositif optoélectronique organique (2), tel qu'un dispositif d'affichage, d'éclairage ou de signalisation à diodes électroluminescentes organiques (« OLED ») ou à cellules photovoltaïques organiques (« OPVC »), ce dispositif comprenant une face utile d'émission ou d'absorption et, vers l'intérieur de cette face, un substrat (3) revêtu d'une matrice de n structures organiques émettrices ou absorbantes de rayonnements (8) intercalées entre et en contact électrique avec des électrodes respectivement proximales (6) et distale (7) vis-à-vis du substrat, des cordons de séparation (9) entre structures organiques réalisés en un matériau électriquement isolant s'étendant entre les électrodes proximales respectives des structures à partir de bords périphériques de ces électrodes proximales, le dispositif comportant une encapsulation étanche (1) à couches minces qui comprend au moins :
- un film inorganique interne (10) surmontant l'électrode distale,
- une couche polymérique photosensible (R) recouvrant ce film interne, et
- un film inorganique externe (13) diélectrique et à effet de barrière recouvrant cette couche polymérique,
**caractérisé en ce que** ladite au moins une couche polymérique est gravée suivant une géométrie discontinue formée de n plots (12) qui surmontent respectivement ces n structures organiques et qui se terminent au-delà de ces dernières au droit desdits cordons, de sorte que les plots deux à deux adjacents soient espacés d'une distance inférieure à la largeur (d₁) des cordons, chaque plot présentant un sommet plan et des flancs également plans sensiblement perpendiculaires audit sommet.

2. Dispositif (2) selon la revendication 1, **caractérisé en ce que** chaque plot présente une hauteur égale ou supérieure à 1 µm.

3. Dispositif (2) selon la revendication 1 ou 2, **caractérisé en ce que** chacun desdits plots (12) déborde de la structure organique (8) sur laquelle il est centré d'une portion périphérique de dépassement, laquelle présente une largeur (d₀) inférieure à la moitié de la largeur (d₁) dudit cordon (9) correspondant.

4. Dispositif (2) selon une des revendications précédentes, **caractérisé en ce que** la surface développée de l'ensemble desdits plots (12) est supérieure à la surface externe qu'aurait ladite au moins une couche polymérique (R) si elle recouvrait de manière continue ledit au moins un film interne (10) suivant une hauteur (z) égale à celle desdits plots.

5. Dispositif (2) selon une des revendications précédentes, **caractérisé en ce que** lesdits plots (12) sont à base d'une résine positive de photolithographie (R) qui est déposée en phase liquide sous forme d'au moins un polymère en solution dans un solvant, cette résine étant de préférence de dénomination « TELR ».

6. Dispositif (2) selon une des revendications précédentes, **caractérisé en ce que** ledit au moins un film interne (10) et/ou externe (13) est/sont déposé(s) par dépôt de couche atomique (« ALD ») ou bien par dépôt chimique en phase vapeur assisté par plasma (« PECVD »), et sont à base d'au moins un composé inorganique choisi dans le groupe constitué par les composés de formule AlₓO_{y}, SiOₓ, SiₓN_{y}, SiOₓN_{y}, ZnSe, Sb₂O₃ et les oxydes transparents conducteurs (OTC) optionnellement combinés à un métal.

7. Dispositif (2) selon la revendication 6, **caractérisé en ce que** ledit au moins un film interne (10) et/ou externe (13) est/sont déposé(s) par « ALD » et sont à base d'au moins un oxyde d'aluminium Al₂O₃ optionnellement combiné à un composé de formule SiOₓ, SiₓN_{y} ou SiOₓN_{y}.

8. Dispositif (2) selon une des revendications précédentes, **caractérisé en ce qu'**il est de type « AM-OLED », à diodes électroluminescentes organiques et à matrice active.

9. Dispositif (2) selon la revendication 8, **caractérisé en ce qu'**il forme un écran dans lequel lesdites structures organiques émettrices (8) forment respectivement des pixels ou des sous-pixels.

10. Dispositif (2) selon la revendication 9, **caractérisé en ce qu'**il forme un écran couleur où chaque pixel est défini par des sous-pixels R, V, B qui sont respectivement formés par lesdites structures organiques émettrices (8) surmontées par lesdits plots (12).

11. Procédé d'encapsulation d'un dispositif (2) selon une des revendications précédentes, **caractérisé en ce qu'**il comprend les étapes successives suivantes :
a) on dépose ledit film inorganique interne (10) au-dessus desdites structures organiques (8) et desdits cordons (9) par exemple directement sur ladite électrode distale (7), par un dépôt de couche atomique (« ALD ») ou bien par un dépôt chimique en phase vapeur assisté par plasma (« PECVD »), ce film étant à base d'au moins un composé inorganique de préférence choisi dans le groupe constitué par les composés de formule AlₓO_{y}, SiOₓ, SiₓN_{y}, SiOₓN_{y}, ZnSe, Sb₂O₃ et les oxydes transparents conducteurs (OTC) optionnellement combinés à un métal,
b) on recouvre de manière continue ce film interne par ladite couche photosensible (R) que l'on dépose en phase liquide par exemple à la tournette sous forme d'au moins un polymère dissous dans un solvant, optionnellement en déposant au préalable sur ce film un promoteur d'adhésion par exemple de type silane,
c) on insole cette couche à des emplacements prédéterminés en la masquant sélectivement des rayonnements d'insolation pour qu'elle soit, d'une part, polymérisée suite à cette insolation au-dessus de chaque structure organique et sur une portion périphérique de dépassement (d₀) de chaque structure organique se terminant au droit dudit cordon l'entourant, et, d'autre part, dépolymérisée ailleurs, de sorte à former lesdits plots (12) espacés surmontant respectivement les structures organiques en les enrobant pour les protéger vis-à-vis de l'étape d),
d) on développe cette couche polymérisée par trempage dans un bain par exemple de type tétraméthyl ammonium hydroxyde, puis
e) on réalise un dépôt conformant à basse température dudit film externe (13) à effet de barrière sous forme de couche recouvrant de manière continue lesdits plots, ce dépôt conformant étant de préférence réalisé par un dépôt de couche atomique (« ALD ») ou un dépôt chimique en phase vapeur assisté par plasma (« PECVD ») d'au moins un composé diélectrique.

12. Procédé d'encapsulation selon la revendication 11, **caractérisé en ce que** l'on met en oeuvre une étape d'amincissement de ladite couche photosensible (R), avant cette étape c) et/ou après cette étape d).

13. Procédé d'encapsulation selon la revendication 11 ou 12, **caractérisé en ce que** l'on met en oeuvre, après cette étape d) ou après cette étape e), une étape de traitement thermique à une température qui est compatible avec la tenue en température du matériau organique et qui peut être comprise entre 60° C et 100° C, pour faciliter le dégazage de ladite couche photosensible (R).

## Patentansprüche

1. Organische optoelektronische Vorrichtung (2), wie zum Beispiel eine Anzeige-, Beleuchtungs- oder Signalisierungsvorrichtung mit organischen Leuchtdioden ("OLED") oder mit organischen photovoltaischen Zellen ("OPVC"), wobei diese Vorrichtung eine Nutzseite zur Emission oder Absorption und nach innen ausgehend von dieser Seite ein Substrat (3) umfasst, welches beschichtet ist mit einer Matrix von n organischen Strukturen zur Emission oder Absorption von Strahlung (8), welche eingeschachtelt zwischen und im elektrischen Kontakt mit gegenüber dem Substrat proximalen (6) und distalen (7) Elektroden sind, wobei aus einem elektrisch isolierenden Material realisierte Trennbänder (9) zwischen organischen Strukturen sich zwischen den jeweiligen proximalen Elektroden der Strukturen ausgehend von peripheren Rändern von deren proximalen Elektroden erstrecken, wobei die Vorrichtung eine dichte Einkapselungsschicht (1) mit Dünnschichten umfasst, welche wenigstens umfasst:
- eine innere anorganische Schicht (10), welche sich über die distale Elektrode erhebt,
- eine photoempfindliche polymere Schicht (R), welche diese innere Schicht bedeckt, und
- eine äußere anorganische Schicht (13), dielektrisch und mit Barrieneffekt, welche diese polymere Schicht bedeckt,
**dadurch gekennzeichnet, dass** die wenigstens eine polymere Schicht strukturiert ist gemäß einer nicht kontinuierlichen Geometrie, welche gebildet ist aus n Blöcken (12), welche sich jeweils über diese n organischen Strukturen erheben und welche jenseits der letzteren direkt unter den Bändern enden, sodass die paarweise benachbarten Blöcke um einen geringeren Abstand als die Breite (d₁) der Bänder beabstandet sind, wobei jeder Block eine ebene Oberseite und ebenfalls im Wesentlichen ebene und zu der Oberseite senkrechte Flanken aufweist.

2. Vorrichtung (2) nach Anspruch 1, **dadurch gekennzeichnet, dass** jeder Block eine Höhe von größer oder gleich 1 µm aufweist.

3. Vorrichtung (2) nach Anspruch 1 oder 2, **dadurch gekennzeichnet, dass** jeder der Blöcke (12), über die organische Struktur (8), auf welcher er zentriert ist, um einen peripheren Überstandabschnitt hinausragt, welcher eine Breite (d₀) kleiner als die Hälfte der Breite (d₁) des entsprechenden Brandes (9) aufweist.

4. Vorrichtung (2) nach einem der vorhergehenden Ansprüche, **dadurch gekennzeichnet, dass** die durch die Anordnung der Blöcke (12) ausgebildete Oberfläche größer ist als die äußere Fläche, welche die wenigstens eine polymere Schicht (R) hätte, wenn sie die wenigstens eine innere Schicht (10) auf kontinuierliche Weise entlang einer Höhe (z) gleich zu derjenigen der Blöcke bedecken würde.

5. Vorrichtung (2) nach einem der vorhergehenden Ansprüche, **dadurch gekennzeichnet, dass** die Blöcke (12) auf Basis eines Positivlithographielacks (R) sind, welcher im flüssigen Zustand in Form wenigstens eines in einem Lösungsmittel gelösten Polymers deponiert ist, wobei dieser Lack bevorzugt die Bezeichnung "TELR" aufweist.

6. Vorrichtung (2) nach einem der vorhergehenden Ansprüche, **dadurch gekennzeichnet, dass** die wenigstens eine innere (10) und/oder äußere (13) Schicht durch Atomlagenabscheidung ("ALD") oder aber durch plasmaunterstützte chemische Dampfphasenabscheidung ("PECVD") deponiert ist/sind und auf Basis von wenigstens einer anorganischen Verbindung sind, welche ausgewählt ist aus der Gruppe, die gebildet ist durch Verbindungen mit der Formel AlₓO_{y}, SiOₓ, SiₓN_{y}, SiOₓN_{y}, ZnSe, Sb₂O₃ und transparente leitende Oxide (OTC), optional kombiniert mit einem Metall.

7. Vorrichtung (2) nach Anspruch 6, **dadurch gekennzeichnet, dass** die wenigstens eine innere (10) und/oder äußere (13) Schicht durch "ALD" deponiert ist/sind und auf Basis wenigstens eines Aluminiumoxids Al₂O₃ sind, optional kombiniert mit einer Verbindung der Formel SiOₓ, SiₓN_{y} oder SiOₓN_{y}.

8. Vorrichtung (2) nach einem der vorhergehenden Ansprüche, **dadurch gekennzeichnet, dass** sie vom "AM-OLED"-Typ, mit organischen Leuchtdioden und aktiver Matrix, ist.

9. Vorrichtung (2) nach Anspruch 8, **dadurch gekennzeichnet, dass** sie einen Bildschirm bildet, bei welchem die emittierenden organischen Strukturen (8) jeweils Pixel oder Subpixel bilden.

10. Vorrichtung (2) nach Anspruch 9, **dadurch gekennzeichnet, dass** sie einen Farbbildschirm bildet, bei welchem jeder Pixel durch Subpixel R, G, B definiert ist, welche jeweils durch die emittierenden organischen Strukturen (8) gebildet sind, über welche sich die Blöcke (12) erheben.

11. Verfahren zur Einkapselung einer Vorrichtung (2) nach einem der vorhergehenden Ansprüche, **dadurch gekennzeichnet, dass** es die folgenden aufeinanderfolgenden Schritte umfasst:
a) es wird die innere anorganische Schicht (10) über den organischen Strukturen (8) und den Bändern (9), beispielsweise direkt auf der distalen Elektrode (7) deponiert, durch Atomlagenabscheidung ("ALD") oder aber durch plasmaunterstützte chemische Dampfphasenabscheidung ("PECVD"), wobei diese Schicht auf Basis von wenigstens einer anorganischen Verbindung ist, welche bevorzugt ausgewählt ist aus der Gruppe, die gebildet ist durch Verbindungen der Formel AlₓO_{y}, SiOₓ, SiₓN_{y}, SiOₓN_{y}, ZnSe, Sb₂O₃ und transparente leitende Oxide (OTC), optional kombiniert mit einem Metall,
b) es wird diese innere Schicht auf kontinuierliche Weise mit der photoempfindlichen Schicht (R) bedeckt, welche im flüssigen Zustand beispielsweise mit einer Schleuder in Form wenigstens eines in einem Lösungsmittel gelösten Polymers deponiert wird, optional indem vorab auf dieser Schicht ein Adhäsionsförderer, beispielsweise vom Silantyp, deponiert wird,
c) es wird diese Schicht an vorbestimmten Stellen belichtet, indem sie selektiv vor Belichtungsstrahlung maskiert wird, sodass sie einerseits infolge dieser Belichtung über jeder organischen Struktur und auf einem peripheren Überstandabschnitt (d₀) jeder organischen Struktur, welche direkt unter dem sie umgebenden Band endet, polymerisiert wird, und anderweitig depolimerisiert wird, sodass die Blöcke (12) ausgebildet werden, welche sich jeweils über die organischen Strukturen erheben und sie einschließen, um sie gegenüber dem Schritt d) zu schützen,
d) es wird diese polymerisierte Schicht entwickelt durch Einweichen in einem Bad, beispielsweise vom Tetramethyl-Ammoniumhydroxid-Typ, und
e) es wird eine konforme Beschichtung bei niedriger Temperatur der äußeren Schicht (13) mit Barriereneffekt in Form einer die Blöcke auf kontinuierliche Weise bedeckenden Schicht realisiert, wobei diese konforme Abscheidung bevorzugt realisiert ist durch Atomlagenabscheidung ("ALD") oder plasmaunterstützte chemische Dampfphasenabscheidung ("PECVD") wenigstens einer dielektrischen Verbindung.

12. Einkapselungsverfahren nach Anspruch 11, **dadurch gekennzeichnet, dass** es einen Schritt eines Dünnermachens der photoempfindlichen Schicht (R) vor diesem Schritt c) und/oder nach diesem Schritt d) einsetzt

13. Einkapselungsverfahren nach Anspruch 11 oder 12, **dadurch gekennzeichnet, dass** es nach diesem Schritt d) oder nach diesem Schritt e) einen Schritt einer thermischen Behandlung mit einer Temperatur einsetzt, welche kompatibel mit der Temperaturfestigkeit des organischen Materials ist und welche zwischen 60°C und 100°C enthalten sein kann, um das Entgasen der photoempfindlichen Schicht (R) zu erleichtern.

## Claims

1. An organic optoelectronic device (2), such as a display, illuminating or signaling device comprising organic light-emitting diodes (OLEDs) or organic photovoltaic cells (OPVCs), this device comprising a useful emission or absorption face and, toward the interior of this face, a substrate (3) coated with a matrix of n organic radiation-emitting or radiation-absorbing structures (8) inserted between and making electrical contact with electrodes that are proximal (6) and distal (7) with respect to the substrate, respectively, separating beads (9) being placed between the organic structures, these beads being made of an electrical insulator and extending between the respective proximal electrodes of the structures from peripheral edges of these proximal electrodes, the device comprising a thin-film-comprising airtight encapsulation (1), which comprises at least:
- one internal inorganic film (10) surmounting the distal electrode;
- one photosensitive polymer layer (R) covering this internal film; and
- one external inorganic dielectric barrier film (13) covering this polymer layer,
**characterized in that** said at least one polymer layer is etched with a discontinuous geometry formed from n pads (12) that respectively surmount these n organic structures, and that terminate beyond the latter in line with said beads, so that pairwise adjacent pads are spaced apart by a distance less than the width (d₁) of the beads, each pad having a flat top and also flat flanks that lie substantially perpendicular to said top.

2. The device (2) as claimed in claim 1, **characterized in that** each pad is 1 µm or more in height.

3. The device (2) as claimed in either of claims 1 and 2, **characterized in that** a peripheral protruding portion of each of said pads (12) protrudes beyond the organic structure (8) on which said pad is centered, which peripheral portion has a width (d₀) less than half the width (d₁) of said corresponding bead (9).

4. The device (2) as claimed in one of the preceding claims, **characterized in that** the developed surface area of all of said pads (12) is greater than the external surface area that said at least one polymer layer (R) would have had if it continuously covered said at least one internal film (10) with a height (z) equal to that of said pads.

5. The device (2) as claimed in one of the preceding claims, **characterized in that** said pads (12) are based on a positive photoresist (R) that is deposited in liquid phase, in the form of at least one polymer dissolved in a solvent, this resist preferably being a "TELR" resist.

6. The device (2) as claimed in one of the preceding claims, **characterized in that** said at least one internal film (10) and/or said at least one external film (13) is/are deposited by atomic layer deposition (ALD) or else by plasma enhanced chemical vapor deposition (PECVD), and are based on at least one inorganic compound chosen from the group consisting of compounds of formula AlₓO_{y}, SiOₓ, SiₓN_{y}, SiOₓN_{y}, ZnSe, Sb₂O₃ and the transparent conductive oxides (TCOs), optionally combined with a metal.

7. The device (2) as claimed in claim 6, **characterized in that** said at least one internal film (10) and/or said at least one external film (13) is/are deposited by ALD and are based on at least one aluminium oxide Al₂O₃, optionally combined with a compound of formula SiOₓ, SiₓN_{y} or SiOₓN_{y}.

8. The device (2) as claimed in one of the preceding claims, **characterized in that** it is an active matrix organic light-emitting diode or AMOLED.

9. The device (2) as claimed in claim 8, **characterized in that** it is a display in which said organic emitting structures (8) respectively form pixels or subpixels.

10. The device (2) as claimed in claim 9, **characterized in that** it is a color display in which each pixel is defined by R, G, B subpixels that are respectively formed by said organic emitting structures (8) surmounted by said pads (12).

11. A process for encapsulating a device (2) according to one of the preceding claims, **characterized in that** it comprises the following steps in succession:
a) said internal inorganic film (10) is deposited over said organic structures (8) and said beads (9), for example directly on said distal electrode (7), by atomic layer deposition (ALD) or even by plasma enhanced chemical vapor deposition (PECVD), this film being based on at least one inorganic compound preferably chosen from the group consisting of compounds of formula AlₓO_{y}, SiOₓ, SiₓN_{y}, SiOₓN_{y}, ZnSe, Sb₂O₃ and the transparent conductive oxides (TCOs), optionally combined with a metal;
b) this internal film is continuously covered with said photosensitive layer (R), which is deposited, for example by spin coating, in liquid phase, in the form of at least one polymer dissolved in a solvent, an adhesion promoter, for example of this silane type, optionally being deposited beforehand on this film;
c) this layer is exposed in preset locations by selectively masking it from exposing radiation so that it is, firstly, following this exposure, polymerized above each organic structure and in a protruding peripheral portion (d₀) of each organic structure terminating in line with said surrounding bead, and secondly, depolymerized elsewhere, so as to form said spaced pads (12) respectively surmounting the organic structures and coating them in order to protect them in step d);
d) this polymerized layer is developed by dipping in a bath, for example a bath of tetramethyl ammonium hydroxide; and then
e) said external barrier film (13) is deposited in the form of a layer continuously covering said pads by conformal low-temperature deposition, this conformal deposition preferably being carried out by atomic layer deposition (ALD) or plasma enhanced chemical vapor deposition (PECVD) of at least one dielectric compound.

12. The encapsulation process as claimed in claim 11, **characterized in that** a step of thinning said photosensitive layer (R) is carried out before step c) and/or after step d).

13. The encapsulation process as claimed in either of claims 11 and 12, **characterized in that** a heat treatment step is carried out, after step d) or after step e), at a temperature that is compatible with the temperature withstand of the organic material, and that may be comprised between 60°C and 100°C, in order to facilitate the degassing of said photosensitive layer (R).
